# EUROPEAN PATENT APPLICATION

(11) **EP 4 697 607 A1**
(43) Date of publication of application: **18.02.2026**
(21) Application number: 24811258.3
(22) Date of filing: 11.04.2024
(51) Int. Cl.: H04B 1/04, H04B 1/40, H04W 52/52

(54) **ELECTRONIC DEVICE INCLUDING POWER SOURCE SENSING CIRCUIT IN FRONT END MODULE FOR WIRELESS ENVIRONMENT**

(30) Priority: 23.05.2023 KR 20230066603; 19.06.2023 KR 20230078539
(71) Applicant: Samsung Electronics Co., Ltd., Suwon-si, Gyeonggi-do 16677 (KR)
(72) Inventor: KIM, Jonghyuk, Suwon-si, Gyeonggi-do 16677 (KR)
(74) Representative: HGF
(86) International application number: PCT/KR2024/004869
(87) International publication number: WO 2024/242319

(57) **Abstract**

This electronic device may comprise: a first antenna and a second antenna; a power source supply circuit; a switch; a power amplifier (PA) connected to the power source supply circuit through the switch in order to obtain transmit power of a first wireless signal transmitted through the first antenna on the basis of a voltage received from the power source supply circuit; a first front end module (FEM) including a control circuit; and a second FEM including a PA connected to the power source supply circuit in order to obtain transmit power of a second wireless signal transmitted through the second antenna on the basis of the voltage received from the power source supply circuit.

## Description

### [Technical Field]

The disclosure relates to an electronic device including power sensing circuitry in a front end module for a wireless environment.

### [Background Art]

An electronic device may include front end modules (FEMs) to transmit and/or receive a signal on each of various frequencies. For example, each of the FEMs may include a power amplifier (PA) for a transmit power of a signal to be transmitted from the electronic device through each of antennas connected to each of the FEMs.

The above-described information may be provided as related art for the purpose of helping to understand the present disclosure. No claim or determination is raised as to whether any of the above-described information may be applied as a prior art related to the present disclosure.

### [Disclosure]

### [Technical Solution]

According to an example embodiment, an electronic device is provided. The electronic device may comprise a first antenna and a second antenna. The electronic device may comprise a power supply circuitry. The electronic device may comprise a first front end module (FEM) including a switch, a power amplifier (PA) connected to the power supply circuitry through the switch to obtain a transmit (Tx) power of a first wireless signal transmitted through the first antenna based on a voltage from the power supply circuitry, and a control circuitry. The electronic device may comprise a second FEM including a PA connected to the power supply circuitry to obtain a Tx power of a second wireless signal transmitted through the second antenna based on the voltage from the power supply circuitry. The control circuitry may be configured to obtain a signal indicating whether the PA in the first FEM connected to the power supply circuitry through the switch is at least partially damaged. The control circuitry may be configured to control the switch to disconnect the power supply circuitry from the PA in the first FEM, in response to the signal indicating that the PA in the first FEM is at least partially damaged.

According to an example embodiment, an electronic device is provided. The electronic device may comprise: at least one processor, comprising processing . The electronic device may comprise a first antenna and a second antenna. The electronic device may comprise a power supply circuitry. The electronic device may comprise a first front end module (FEM) including a switch, a power amplifier (PA) connected to the power supply circuitry through the switch to obtain a transmit (Tx) power of a first wireless signal obtained from the at least one processor and transmitted through the first antenna based on a voltage from the power supply circuitry, and a control circuitry. The electronic device may comprise a second FEM including a PA connected to the power supply circuitry to obtain a Tx power of a second wireless signal obtained from the at least one processor and transmitted through the second antenna based on the voltage from the power supply circuitry. The control circuitry may be configured to obtain, from the processor, a signal indicating that the PA in the first FEM connected to the power supply circuitry through the switch is at least partially damaged. The control circuitry may be configured to control the switch to disconnect the power supply circuitry from the PA in the first FEM, in response to the signal.

According to an example embodiment, an electronic device is provided. The electronic device may comprise: at least one processor, comprising processing circuitry. The electronic device may comprise a first antenna and a second antenna. The electronic device may comprise a power supply circuitry. The electronic device may comprise a first front end module (FEM) including a switch, a power amplifier (PA) connected to the power supply circuitry through the switch to obtain a transmit (Tx) power of a first wireless signal obtained from the at least one processor and transmitted through the first antenna based on a voltage from the power supply circuitry, and control circuitry. The electronic device may comprise a second FEM including a PA connected to the power supply circuitry to obtain a Tx power of a second wireless signal obtained from the at least one processor and transmitted through the second antenna based on the voltage from the power supply circuitry. The control circuitry may be configured to identify that the PA in the first FEM is at least partially damaged by identifying a state of the switch disconnecting the power supply circuitry from the PA in the first FEM. The control circuitry may be configured to provide data indicating that the PA in first FEM is at least partially damaged to the at least one processor, in response to the identification.

### [Description of the Drawings]

The above and other aspects, features and advantages of certain embodiments of the present disclosure will be more apparent from the following detailed description, taken in conjunction with the accompanying drawings, in which:
FIG. 1 illustrates an example in which a power amplifier (PA) in a front end module (FEM) is damaged.
FIG. 2 illustrates an exemplary electronic device including a switch for disconnecting a PA from a power supply circuitry in an FEM.
FIGS. 3 and 4 illustrate an example of a comparator connected to a PA.
FIG. 5 illustrates an example of operations of a control circuitry in an FEM executed in response to a signal provided from a power sensing circuitry.
FIG. 6 illustrates an example of operations of a processor executed in response to a signal provided from a power sensing circuitry.
FIG. 7 illustrates an example of operations of a control circuitry executed in response to a signal provided to a switch from a power sensing circuitry.
FIG. 8 illustrates an exemplary electronic device including an FEM that includes a switch adaptively connectable to a first power supply circuitry or a second power supply circuitry.
FIG. 9 illustrates an exemplary electronic device including a plurality of PAs in an FEM.
FIGS. 10 and 11 illustrate an example of a switch in an FEM for changing a state of a connection from a plurality of PAs.
FIG. 12 is a block diagram of an electronic device in a network environment according to various embodiments.

### [Mode for Invention]

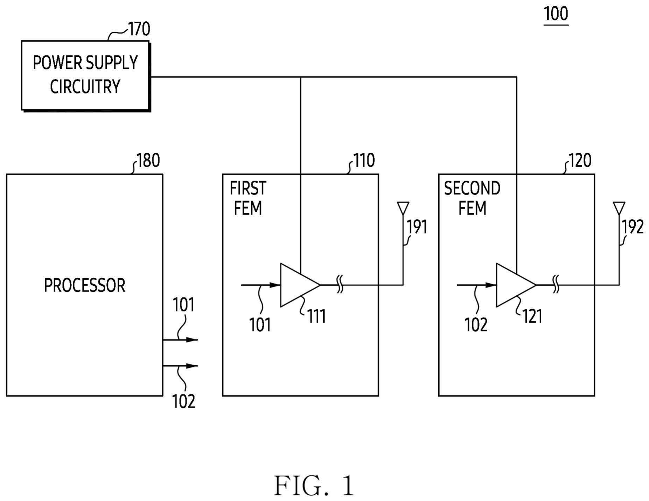

FIG. 1 illustrates an example in which a power amplifier (PA) in a front end module (FEM) is damaged.

Referring to FIG. 1, an electronic device 100 may include a first FEM (e.g., comprising circuitry) 110, a second FEM (e.g., comprising circuitry) 120, power supply circuitry 170, a processor (e.g., including processing circuitry) 180, a first antenna 191, and a second antenna 192.

The first FEM 110 may be used to transmit a wireless signal 101 through the first antenna 191. For example, the first FEM 110 may include a PA 111. The PA 111 may be configured to obtain a transmit power of the wireless signal 101 transmitted through the first antenna 191. The wireless signal 101 may be obtained or generated by the processor 180. For example, the wireless signals 101 may be provided from the processor 180 (e.g., an application processor (AP) and/or a communication processor (CP)) to the PA 111. For example, the wireless signal 101 may be provided to the PA 111 from the processor 180 through a radio frequency integrated circuit (RFIC) (not shown in FIG. 1). For example, the transmit power of the wireless signal 101 may be obtained based on a voltage (e.g., a voltage (Vcc) for a dynamic range of the PA 111) provided to the PA 111 from the power supply circuitry 170 connected to the PA 111.

The second FEM 120 may be used to transmit a wireless signal 102 through the second antenna 192. For example, the second FEM 120 may include a PA 121. The PA 121 may be configured to obtain a transmit power of the wireless signal 102 transmitted through the second antenna 192. The wireless signal 102 may be obtained or generated by the processor 180. For example, the wireless signal 102 may be provided from the processor 180 (e.g., the AP and/or the CP) to the PA 121. For example, the wireless signal 102 may be provided to the PA 111 from the processor 180 through the RFIC. For example, the transmit power of the wireless signal 102 may be obtained based on a voltage (e.g., a voltage (Vcc) for a dynamic range of the PA 121) provided to the PA 121 from the power supply circuitry 170 connected to the PA 121.

For example, the PA 111 may be at least partially damaged (or broken down).

For example, the voltage from the power supply circuitry 170 provided to the PA 111, which is partially damaged (or malfunctioned), may burn the PA 111. For example, the voltage from the power supply circuitry 170 provided to the partially damaged PA 111 may burn not only the PA 111 but also the electronic device 100.

For example, the power supply circuitry 170 may be connected to each of the PA 111 and the PA 121. For example, since the power supply circuitry 170 is connected to the PA 111 and the PA 121, damage of at least a part of the PA 111 may affect the PA 121 that shares the power supply circuitry 170 with the PA 111. For example, the PA 111 (e.g., a transistor in the PA 111 (not shown in FIG. 1)) may be short-circuited. For example, providing the voltage from the power supply circuitry 170 to the PA 121 may be interrupted by the short-circulated PA 111. For example, use of the PA 121 may be limited due to the short-circulated PA 111.

As illustrated above, the PA 111, which is at least partially damaged (or out of order), may cause a decrease in usability (e.g., degradation of device stability and/or degradation of communication performance) of the electronic device 100 .

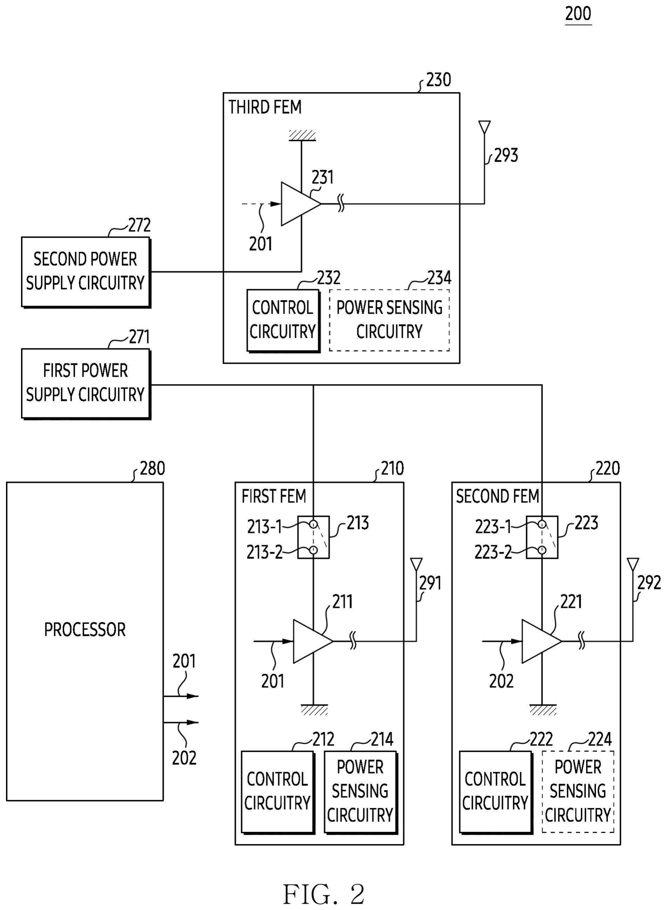

An electronic device to be illustrated below may include a first component for identifying that a PA in an FEM connected to a power supply circuitry is at least partially damaged and a second component for disconnecting the power supply circuitry from the PA in the FEM in response to the identification. The electronic device may be illustrated and described in greater detail below with reference to FIG. 2.

FIG. 2 illustrates an exemplary electronic device including a switch for disconnecting a PA from a power supply circuitry in an FEM.

Referring to FIG. 2, an electronic device 200 may include a first FEM (e.g., including various circuitry) 210, a second FEM (e.g., including various circuitry) 220, a first power supply circuitry 271 (e.g., a first power modulator 271), a processor (e.g., including processing circuitry) 280, a first antenna 291, and a second antenna 292. As a non-limiting example, the electronic device 200 may further include a third FEM (e.g., including various circuitry) 230, a second power supply circuitry 272 (e.g., a second power modulator 272), and a third antenna 293.

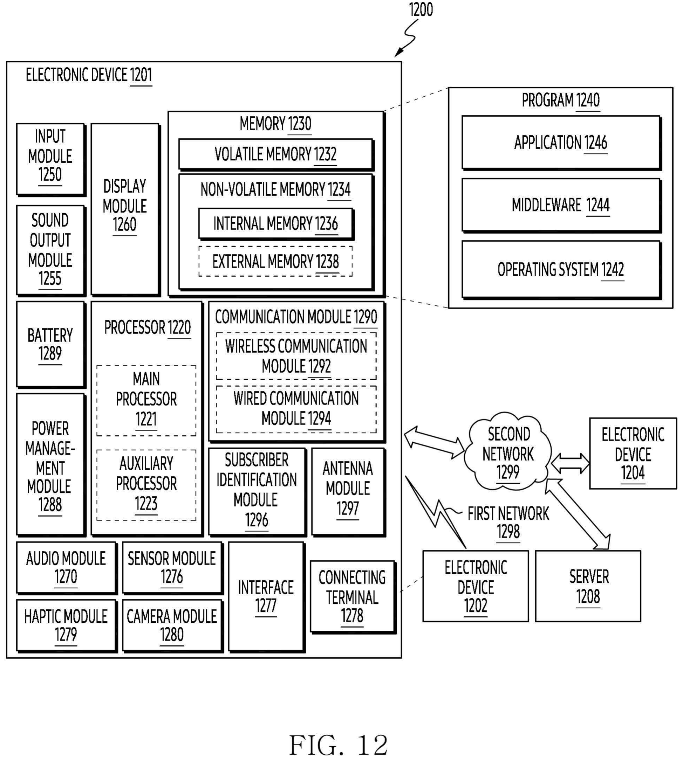

The processor 280 may be used to generate or obtain a wireless signal (e.g., a wireless signal 201 and/or a wireless signal 202) to be transmitted through each of a plurality of antennas including the first antenna 291 and the second antenna 292. For example, the processor 280 may include an application processor (AP) and/or a communication processor (CP). For example, the processor 280 may include at least a part of a processor 1220 of FIG. 12 or may correspond to at least a part of the processor 1220 of FIG. 12. The processor 280 according to an embodiment of the disclosure may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions.

Each of the first FEM 210 and the second FEM 220 may be used for a wireless signal transmitted through each of the first antenna 291 and the second antenna 292. For example, each of the first FEM 210 and the second FEM 220 may include at least a part of a wireless communication module 1292 and/or at least a part of an antenna module 1297 of FIG. 12 or may correspond to at least a part of the wireless communication module 1292 and/or at least a part of the antenna module 1297 of FIG. 12.

For example, each of the first FEM 210 and the second FEM 220 may obtain the wireless signal generated or obtained by the processor 280. For example, the wireless signal may be provided to each of the first FEM 210 and the second FEM 220, through a radio frequency integrated circuit (RFIC) (not shown in FIG. 2) from the processor 280. For example, the RFIC may include a digital-to-analog converter (DAC). For example, the RFIC may include an oscillator and a mixer for frequency up-conversion. For example, the first FEM 210 may obtain the wireless signal 201 from the processor 280. For example, the second FEM 220 may obtain the wireless signal 202 from the processor 280.

For example, the first FEM 210 may include a PA 211, a control circuitry 212, a switch 213, and a power sensing circuitry 214.

For example, the PA 211 may be configured to obtain a transmit power of the wireless signal 201 transmitted through the first antenna 291. For example, the transmit power of the wireless signal 201 may be obtained based on a voltage provided from the first power supply circuitry 271 (e.g., a voltage (Vcc) for a dynamic range of the PA 211).

For example, the control circuitry 212 may be used to control at least a part of components (e.g., the PA 211, the switch 213, and/or the power sensing circuitry 214) in the first FEM 210. For example, the control circuitry 212 may change a state of at least a part of the components based on control data, control information, a control signal, and/or a control command obtained from the processor 280. The control data, the control information, the control signal, and/or the control command may be provided from the processor 280 to the control circuitry 212 through an interface (e.g., a mobile industry processor interface (MIPI)) between the processor 280 and the control circuitry 212. The interface may be further used to provide data, information, a command, or a signal from the control circuitry 212 to the processor 280.

As a non-limiting example, the control circuitry 212 may change a state of at least a part of the components independently of control of the processor 280 (or without the control of the processor 280).

For example, the switch 213 may be configured to connect the first power supply circuitry 271 to the PA 211 and disconnect the first power supply circuitry 271 from the PA 211. For example, the switch 213 may include a first terminal 213-1 connected to the first power supply circuitry 271 and a second terminal 213-2 connected to the PA 211. For example, the switch 213 may have a first state for connecting the first terminal 213-1 to the second terminal 213-2 and a second state for disconnecting the first terminal 213-1 from the second terminal 213-2. For example, the control circuitry 212 may set a state of the switch 213 to the first state or set the state to the second state, in response to the control data, the control information, the control signal, and/or the control command from the processor 280. As a non-limiting example, the control circuitry 212 may set the state to the first state or set the state to the second state, independently of the control of the processor 280 (or without the control of the processor 280). The state may be changed from the first state to the second state or from the second state to the first state. The switch 213 may be the second component.

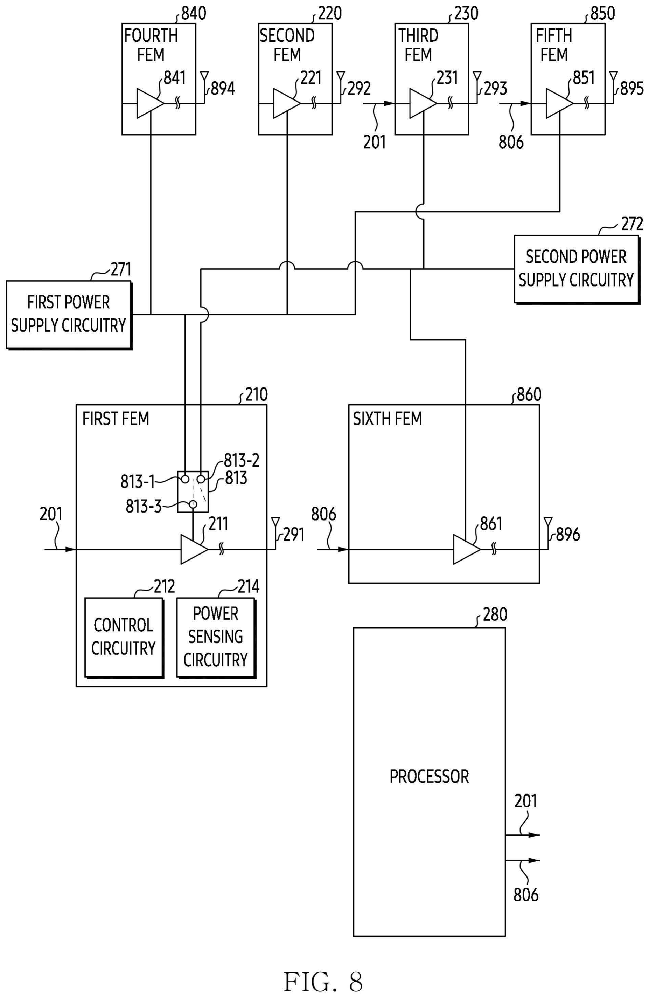

As a non-limiting example, the switch 213 may be replaced with a switch for forming a connection between the first power supply circuitry 271 and the PA 211 and a connection between the second power supply circuitry 272 and the PA 211. These switches will be described in greater detail below with reference to FIG. 8.

For example, the power sensing circuitry 214 may be used to identify whether the PA 211 is at least partially damaged. For example, the power sensing circuitry 214 may be the first component. For example, the power sensing circuitry 214 may sense or identify a voltage of each of nodes of the PA 211. For example, the power sensing circuitry 214 may output or provide a signal indicating whether a difference value between a voltage of a first node of the PA 211 and a voltage of a second node of the PA 211 is less than a reference value. The signal may be provided to the control circuitry 212, the switch 213, or the processor 280.

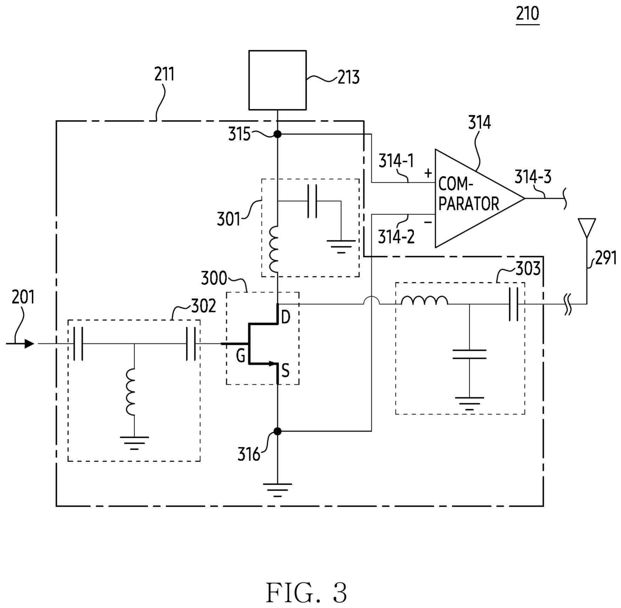

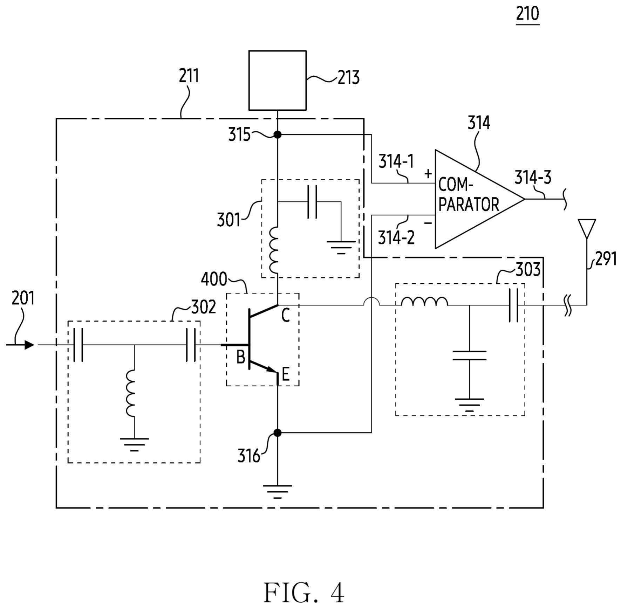

For example, the power sensing circuitry 214 (or a voltage sensing circuitry 214) may include a power distribution circuitry (or a voltage distribution circuitry). For example, the power sensing circuitry 214 may include a comparator. The comparator may be described in greater detail below with reference to FIGS. 3 and 4.

FIGS. 3 and 4 illustrate an example of a comparator connected to a PA.

Referring to FIG. 3, a PA 211 in a first FEM 210 may include a field effect transistor (FET) 300, a first matching circuitry 301, a second matching circuitry 302, and a third matching circuitry 303.

For example, the FET 300 may include a drain D connected to a switch 213 through the first matching circuitry 301, a gate G configured to obtain a wireless signal 201 through the second matching circuitry 302, and a source S connected to a ground. For example, the drain may be further connected to the third matching circuitry 303.

For example, each of the first matching circuitry 301, the second matching circuitry 302, and the third matching circuitry 303 may be used for impedance matching. For example, each of the first matching circuitry 301, the second matching circuitry 302, and the third matching circuitry 303 may include passive elements such as at least one capacitor, at least one resistor (not shown in FIG. 3), and/or at least one inductor.

For example, a comparator 314 in the first FEM 210 may include a first input terminal 314-1, a second input terminal 314-2, and an output terminal 314-3.

For example, the first input terminal 314-1 may be connected to a node 315 to which the voltage provided to the PA 211 from a first power supply circuitry 271 is applied. For example, the first input terminal 314-1 may be connected to the drain of the FET 300, unlike shown in FIG. 3.

For example, the second input terminal 314-2 may be connected to a node 316 connected to the source of the FET 300.

For example, the comparator 314 may be connected to each of the node 315 and the node 316 to identify a current flowing from the source to the drain. As a non-limiting example, since the comparator 314 is connected to each of the node 315 and the node 316, the comparator 314 may identify the current rather than estimating the current based on a bias voltage of the FET 300 (or instead of estimating the current based on the bias voltage). For example, the comparator 314 may be used to more accurately identify whether the PA 211 is at least partially damaged (or malfunctioned).

For example, the comparator 314 may be configured to output a signal, from the output terminal 314-3, indicating whether a difference value between a voltage applied to the node 315 (e.g., a voltage provided from the first power supply circuitry 271) and a voltage applied to the node 316 is less than the reference value. As a non-limiting example, the reference value may be about 0.2 voltage (V). For example, the signal above may be provided to the control circuitry 212, the switch 213, or the processor 280.

Referring to FIG. 4, the FET 300 may be replaced with a bipolar junction transistor (BJT) 400. For example, the BJT 400 may include a collector C connected to the switch 213 through the first matching circuitry 301, a base B configured to obtain the wireless signal 201 through the second matching circuitry 302, and an emitter E connected to a ground. For example, the collector may be further connected to the third matching circuitry 303.

For example, the first input terminal 314-1 of the comparator 314 may be connected to the node 315 to which the voltage provided to the PA 211 from the first power supply circuitry 271 is applied. For example, the first input terminal 314-1 may be connected to the collector of the BJT 400.

For example, the second input terminal 314-2 may be connected to the node 316 connected to the emitter of the BJT 400.

For example, the comparator 314 may be connected to each of the nodes 315 and 316 to identify a current flowing from the collector to the emitter. As a non-limiting example, since the comparator 314 is connected to the node 315 and the node 316, the comparator 314 may identify the current rather than estimating the current based on a bias voltage of the BJT 400 (or instead of estimating the current based on the bias voltage). For example, the comparator 314 may be used to more accurately identify whether the PA 211 is at least partially damaged.

For example, the comparator 314 may be configured to output a signal, from the output terminal 314-3, indicating whether a difference value between a voltage applied to the node 315 (e.g., the voltage provided from the first power supply circuitry 271) and a voltage applied to the node 316 is less than the reference value. For example, the signal may be provided to the control circuitry 212, the switch 213, or the processor 280.

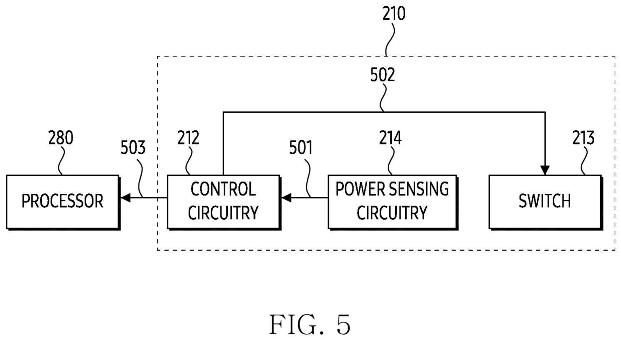

Referring back to FIG. 2, the signal, which is provided or outputted or transmitted from the power sensing circuitry 214, may indicate that the difference value is less than the reference value, or may indicate that the difference value is greater than or equal to the reference value. For example, the signal may indicate that the PA 211 is at least partially damaged as indicating that the difference value is less than the reference value, and indicate that the PA 211 is not damaged (or the PA 211 is within a normal state) as indicating that the difference value is greater than or equal to the reference value. For example, the signal indicating the difference value less than the reference value may cause operations for disconnecting the first power supply circuitry 271 from the PA 211 in the electronic device 200. The operations may vary according to a component receiving the signal. The operations may be illustrated in greater detail below with reference to FIGS. 5, 6 and 7.

FIG. 5 illustrates an example of operations of a control circuitry in an FEM executed in response to a signal provided from a power sensing circuitry.

Referring to FIG. 5, a power sensing circuitry 214 may provide a control circuitry 212 with a signal indicating whether the difference value is less than the reference value, in operation 501. The signal may indicate that the difference value is less than the reference value. The signal may indicate that the difference value is greater than or equal to the reference value.

The control circuitry 212 may control a switch 213 according to control of a processor 280 in response to the signal indicating the difference value greater than or equal to the reference value.

The control circuitry 212 may control the switch 213 in operation 502, in response to the signal indicating the difference value less than the reference value. For example, the control circuitry 212 may control the switch 213 to disconnect the first power supply circuitry 271 from the PA 211, in response to the signal indicating the difference value less than the reference value. For example, the control circuitry 212 may change the state of the switch 213 from the first state to the second state, in response to the signal indicating the difference value less than the reference value.

As a non-limiting example, the control circuitry 212 may refrain from or disable changing the state of the switch 213 from the second state to the first state according to control of the processor 280, in response to the signal indicating the difference value less than the reference value. For example, even when obtaining a control signal indicating that the switch 213 is set to the first state from the processor 280 after the signal indicating the difference value less than the reference value is obtained, the control circuitry 212 may maintain the second state of the switch 213. For example, the second state of the switch 213 may be maintained independently of (regardless of) control from the processor 280.

In operation 503, the control circuitry 212 may provide the processor 280 with a signal indicating that the difference value is less than the reference value or that the PA 211 is at least partially damaged, in response to the signal indicating the difference value less than the reference value. For example, the control circuitry 212 may transfer the signal provided from the power sensing circuitry 214 to the processor 280. For example, the control circuitry 212 may provide the processor 280 with a signal (or data), which is newly obtained (or generated) based on the signal provided from the power sensing circuitry 214 and indicates that the PA 211 is at least partially damaged.

The processor 280 may refrain from, or cease, or bypass, or terminate transmitting the wireless signal 201 using the PA 211 in the first FEM 210, based on the signal provided from the control circuitry 212 in operation 503. For example, the processor 280 may transmit the wireless signal 201 using another FEM (e.g., a PA (e.g., the PA 231) in the third FEM 230) distinct from the first FEM 210, based on the signal, instead of transmitting the wireless signal 201 using the PA 211 in the first FEM 210. Transmitting the wireless signal 201 using a PA in the other FEM will be illustrated in the following description.

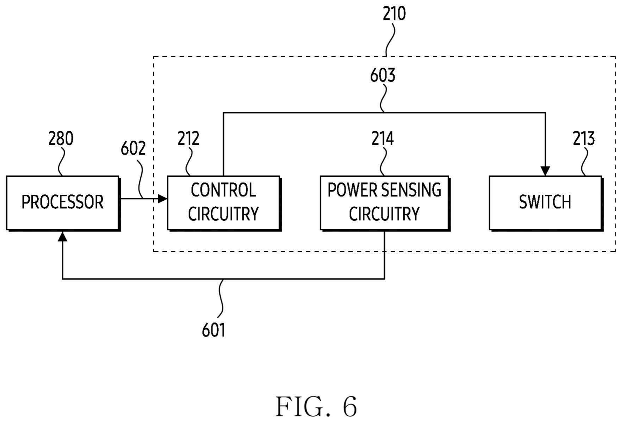

Since the control of the switch 213 illustrated in the description of FIG 5 is executed by the control circuitry 212 included in the first FEM 210 together with the switch 213 according to the signal from the power sensing circuitry 214 in the first FEM 210, disconnecting the first power supply circuitry 271 from the PA 211 as the PA 211 is at least partially damaged may be implemented by operations inside the first FEM 210. For example, the operations illustrated in the description of FIG. 5 may provide control of the switch 213 faster than control of the switch 213 provided from operations to be illustrated in description of FIG. 6.

FIG. 6 illustrates an example of operations of a processor executed in response to a signal provided from a power sensing circuitry.

Referring to FIG. 6, in operation 601, a power sensing circuitry 214 may provide a signal indicating whether the difference value is less than the reference value to a processor 280. For example, the signal may be provided to the processor 280. The signal may indicate that the difference value is less than the reference value. The signal may indicate that the difference value is greater than or equal to the reference value.

The processor 280 may identify or recognize that a PA 211 is not damaged (or the PA 211 is within a normal state) in response to the signal greater than or equal to the reference value. For example, the processor 280 may maintain or enable transmitting a wireless signal 201 using the PA 211, based on the identification (or recognition).

In operation 602, the processor 280 may provide a control circuitry 212 with a control signal indicating (or requesting) that the state of the switch 213 is changed from the first state to the second state or indicating (or requesting) that the state is set to the second state, in response to the signal indicating the difference value less than the reference value.

The processor 280 may refrain from, or cease, or bypass, or terminate transmitting the wireless signal 201 using the PA 211 in a first FEM 210, in response to the signal indicating the difference value less than the reference value. For example, the processor 280 may transmit the wireless signal 201 using a PA in another FEM (e.g., the third FEM 230) distinct from the first FEM 210, based on the signal, instead of transmitting the wireless signal 201 using the PA 211 in the first FEM 210. Transmitting the wireless signal 201 using a PA in the other FEM will be illustrated in the following description.

In operation 603, the control circuitry 212 may control the switch 213 in response to the control signal (e.g., the control signal indicating that the state of the switch 213 is changed from the first state to the second state) obtained or received from the processor 280 according to operation 602. For example, the state of the switch 213 may be set to the second state or changed from the first state to the second state, according to the control of the control circuitry 212.

The control of the switch 213 illustrated in the description of FIG. 6 may be executed by the processor 280 according to the signal from the power sensing circuitry 214 in the first FEM 210. For example, the operations illustrated in the description of FIG. 5 may provide monitoring of the PA 211 faster than monitoring of the PA 211 provided from operations to be illustrated in description of FIG. 6.

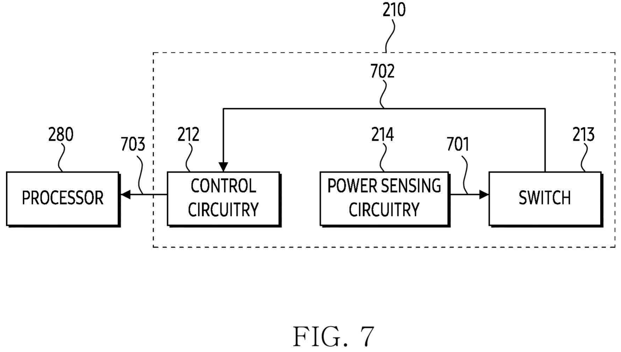

FIG. 7 illustrates an example of operations of a control circuitry executed in response to a signal provided to a switch from a power sensing circuitry.

Referring to FIG. 7, in operation 701, a power sensing circuitry 214 may provide a switch 213 with a signal indicating whether the difference value is less than the reference value. The signal may indicate that the difference value is less than the reference value. The signal may indicate that the difference value is greater than or equal to the reference value.

The switch 213 may maintain a state of the switch 213 based on the signal indicating that the difference value greater than or equal to the reference value. For example, the switch 213 may maintain the state of the switch 213 in the first state, based on the signal indicating that the difference value greater than or equal to the reference value.

For example, in operation 702, a control circuitry 212 may identify the state of the switch 213. For example, the control circuitry 212 may identify or monitor the state of the switch 213 using a register used to control the switch 213 according to a control command of a processor 280. For example, the control circuitry 212 may identify whether the state of the switch 213 is changed from the first state to the second state (or whether the switch 213 is within the second state). For example, in operation 703, the control circuitry 212 may provide the processor 280 with data indicating that the PA 211 is at least partially damaged, in response to identifying that the state is changed from the first state to the second state.

The processor 280 may refrain from, or cease, or bypass, or terminate transmitting the wireless signal 201 using the PA 211 in the first FEM 210, based on the data provided from the control circuit 212 in operation 703. For example, the processor 280 may transmit the wireless signal 201 using a PA in another FEM (e.g., the third FEM 230) distinct from the first FEM 210, based on the signal, instead of transmitting the wireless signal 201 using the PA 211 in the first FEM 210. Transmitting the wireless signal 201 using a PA in the other FEM will be illustrated in the following description.

A state of the switch 213 illustrated in the description of FIG. 7 may be directly changed to the second state according to the signal from the power sensing circuitry 214 in the first FEM 210. For example, operations illustrated in the description of FIG. 7 may provide a change in a state of the switch 213 faster than a change in a state of the switch 213 provided from the operations illustrated in the description of FIG. 5.

Referring back to FIG. 2, a second FEM 220 may include a PA 221 and a control circuitry 222.

For example, the PA 221 may be configured to obtain a transmit power of a wireless signal 202 transmitted through a second antenna 292. For example, the transmit power of the wireless signal 202 may be obtained based on a voltage (e.g., a voltage (Vcc) for a dynamic range of the PA 221) provided from a first power supply circuitry 271.

For example, the control circuitry 222 may be used to control at least a part of components (e.g., the PA 221, the switch 223, and/or the power sensing circuitry 224) in the second FEM 220. For example, the control circuitry 222 may change a state of at least a part of the components based on control data, control information, a control signal, and/or a control command obtained from the processor 280. The control data, the control information, the control signal, and/or the control command may be provided from the processor 280 to the control circuitry 222 through an interface (e.g., MIPI) between the processor 280 and the control circuitry 222. The interface may be further used to provide data, information, a command, or a signal from the control circuitry 222 to the processor 280.

As a non-limiting example, the control circuitry 222 may change a state of at least a part of the components, independently of control of the processor 280 (or without the control of the processor 280).

For example, when the PA 211 is at least partially damaged, the first power supply circuitry 271 may be disconnected from the PA 211 according, for example, to a part of the operations illustrated in the description of FIGS. 5, 6 and 7. For example, the first power supply circuitry 271 may be disconnected from the PA 211 to maintain providing the voltage from the first power supply circuitry 271 to the PA 221 in the second FEM 220. For example, when the short-circulated PA 211 is connected to the first power supply circuitry 271 and the PA 221 is connected to the first power supply circuitry 271, since the PA 221 may not obtain the voltage from the first power supply circuitry 271 due to the short-circulated PA 211, transmitting the wireless signal 202 using the PA 221 may be unavailable. For example, since the first power supply circuitry 271 is disconnected from the short-circulated PA 211 according to a part of the operations illustrated in the description of FIGS. 5 to 7, the first power supply circuitry 271 may provide the PA 221 with the voltage even when the PA 211 is short-circuited.

For example, the second FEM 220 may further include a switch 223 and a power sensing circuitry 224.

For example, the switch 223 may be configured to connect the first power supply circuitry 271 to the PA 221 and disconnect the first power supply circuitry 271 from the PA 221. For example, the switch 223 may include a first terminal 223-1 connected to the first power supply circuitry 271 and a second terminal 223-2 connected to the PA 221. For example, the switch 223 may have a first state for connecting the first terminal 223-1 to the second terminal 223-2, and a second state for disconnecting the first terminal 223-1 from the second terminal 223-2. For example, the control circuitry 222 may set a state of the switch 223 to the first state or the state to the second state, in response to the control data, the control information, the control signal, and/or the control command from the processor 280. As a non-limiting example, the control circuitry 222 may set the state to the first state or the state to the second state, independently of control of the processor 280 (or without the control of the processor 280). For example, the state may be changed from the first state to the second state or from the second state to the first state. For example, the switch 223 may be the second component.

As a non-limiting example, the switch 223 may be replaced with a switch for forming a connection between the first power supply circuitry 271 and the PA 221 and a connection between the second power supply circuitry 272 and the PA 221. Such switch will be described in greater detail below with reference to FIG. 8.

For example, the power sensing circuitry 224 may be used to identify whether the PA 221 is at least partially damaged. For example, the power sensing circuitry 224 may be the first component. For example, the power sensing circuitry 224 may sense or identify a voltage of each of nodes of the PA 221. For example, the power sensing circuitry 224 may output or provide a signal indicating whether a difference value between a voltage of a first node of the PA 221 and a voltage of a second node of the PA 221 is less than a reference value. The signal may be provided to the control circuitry 222, the switch 223, or the processor 280. For example, the power sensing circuitry 224 may be implemented as the comparator illustrated in the description of FIGS. 3 and 4.

For example, the control circuitry 222, the switch 223, and the power sensing circuitry 224 may execute operations, which are the same or similar to operations of the control circuitry 212, the switch 213, and the power sensing circuitry 214 illustrated in the descriptions of FIGS. 5 to 7. As a non-limiting example, the control circuitry 222 may obtain a signal indicating whether the PA 221 connected to the first power supply circuitry 271 through the switch 223 is at least partially damaged. As a non-limiting example, the control circuitry 222 may disconnect the first power supply circuitry 271 from the PA 221, in response to the signal indicating that the PA 221 is at least partially damaged. As a non-limiting example, the control circuitry 222 may maintain a connection between the PA 221 and the first power supply circuitry 271 through the switch 223, based on the signal indicating that the PA 221 is not damaged (or the PA 221 is within a normal state).

For example, as illustrated in the description of FIGS. 5, 6 and 7, the processor 280 may transmit the wireless signal 201 using a PA in another FEM, instead of at least partially damaged PA 211.

For example, the processor 280 may cease providing the first FEM 210 with the wireless signal 201, in response to the signal (e.g., the signal indicating that the PA 211 is at least partially damaged) obtained according to operation 503 of FIG. 5, the signal (e.g., the signal indicating that the difference value is less than the reference value) obtained according to operation 601 of FIG. 6, or the data (e.g., the data indicating that the PA 211 is at least partially damaged) obtained according to operation 703 of FIG. 7. For example, use of the first FEM 210 may be limited or disabled, in response to the signal obtained according to operation 503 of FIG. 5, the signal obtained according to operation 601 of FIG. 6, or the data obtained according to operation 703 of FIG. 7.

For example, the processor 280 may identify the other FEM replacing the first FEM 210 including the PA 211 as the third FEM 230, in response to the signal obtained according to operation 503 of FIG. 5, the signal obtained according to operation 601 of FIG. 6, or the data obtained according to operation 703 of FIG. 7. For example, the processor 280 may identify a third FEM 230 supporting a frequency band of the wireless signal 201 among all FEMs in the electronic device 200. As a non-limiting example, the third FEM 230 is an FEM used for dual connectivity (e.g., evolved universal mobile telecommunication system (UMTS) terrestrial radio access (E-UTRA) new radio (NR) dual connectivity (DC) (EN-DC) and/or NR E-UTRA DC (NE-DC)) together with the second FEM 220, and may support the frequency band. The identification of the third FEM 230 may be performed using reference data stored in a nonvolatile memory (e.g., at least a part of a memory 1230 of FIG. 12) in an electronic device 200. The reference data will be described in greater detail below with reference to FIG. 8.

For example, the processor 280 may provide the wireless signal 201 to the third FEM 230 supporting the frequency band. For example, the wireless signal 201 may be transmitted through a third antenna 293 using the third FEM 230. For example, the wireless signal 201 may be transmitted through the third antenna 293 with a transmit power obtained based on the PA 231. For example, the transmit power may be obtained based on a voltage provided to the PA 231 from the second power supply circuitry 272.

As described above, since the wireless signal 201 is transmitted using the third FEM 230 in the electronic device 200 supporting the frequency band even when the PA 211 in the first FEM 210 is damaged, the electronic device 200 may provide an enhanced communication service.

For example, the third FEM 230 may further include a control circuitry 232 and a power sensing circuitry 234, like the first FEM 210. For example, although not shown in FIG. 2, the third FEM 230 may further include a switch configured to connect the second power supply circuitry 272 to the PA 231 and disconnect the second power supply circuitry 272 from the PA 231. For example, the control circuitry 232, the power sensing circuitry 234, and the switch may perform operations, which are the same or similar to operations illustrated in the description of FIGS. 5, 6 and 7.

As illustrated above, the switch 213 may be replaced with a switch configured to connect one of power supply circuits (e.g., the first power supply circuitry 271 and the second power supply circuitry 272) in the electronic device 200 to the PA 211. Such switch may be illustrated in description of FIG. 8.

FIG. 8 illustrates an exemplary electronic device including an FEM that includes a switch adaptively connectable to a first power supply circuitry or a second power supply circuitry.

Referring to FIG. 8, an electronic device 200 may further include a fourth FEM (e.g., including various circuitry) 840, a fifth FEM (e.g., including various circuitry) 850, a sixth FEM (e.g., including various circuitry) 860, a fourth antenna 894, a fifth antenna 895, and a sixth antenna 896.

For example, the fourth FEM 840 may include a PA 841. For example, the PA 841 may be configured to obtain a transmit power of a wireless signal transmitted through the fourth antenna 894. For example, the transmit power may be obtained based on the voltage (e.g., a voltage (Vcc) for a dynamic range of the PA 841) from a first power supply circuitry 271 connected to the PA 841.

For example, the fifth FEM 850 may include a PA 851. For example, the PA 851 may be configured to obtain a transmit power of a wireless signal transmitted through the fifth antenna 895. For example, the transmit power may be obtained based on the voltage (e.g., a voltage (Vcc) for a dynamic range of the PA 851) from a first power supply circuitry 271 connected to the PA 851.

For example, the sixth FEM 860 may include a PA 861. For example, the PA 861 may be configured to obtain a transmit power of a wireless signal transmitted through the sixth antenna 896. For example, the transmit power may be obtained based on the voltage (e.g., a voltage (Vcc) for a dynamic range of the PA 861) from a first power supply circuitry 272 connected to the PA 861.

For example, the first FEM 210 may include a switch 813 replacing the switch 213. The switch 813 may include a first terminal 813-1 connected to the first power supply circuitry 271, a second terminal 813-2 connected to the second power supply circuitry 272, and a third terminal 813-3 connected to the PA 211. For example, the switch 813 may have a first state connecting the third terminal 813-3 to the first terminal 813-1, a second state connecting the third terminal 813-3 to the second terminal 813-2, and a third state disconnecting the third terminal 813-3 from both the first terminal 813-1 and the second terminal 8-2.

For example, when the PA 211 is at least partially damaged, the control circuitry 212 may control the switch 813 according to a part of the operations illustrated in the description of FIGS. 5 to 7. For example, when the PA 211 is at least partially damaged, the control circuitry 212 may disconnect the first power supply circuitry 271 from the PA 211 by disconnecting the third terminal 813-3 from the first terminal 813-1, and disconnect the second power supply circuitry 272 from the PA 211 by disconnecting the third terminal 813-3 from the second terminal 813-2. For example, the control circuitry 212 may disconnect the first power supply circuitry 271 from the PA 211 by disconnecting the third terminal 813-3 from the first terminal 813-1, in order to prevent and/or reduce use of each of the second FEM 220, the fourth FEM 840, and the fifth FEM 850 (or use of each of the PA 221, the PA 841, and the PA 851) respectively connected to the first power supply circuitry 271 from being at least partially restricted due to at least partially damaged PA 211. For example, the control circuitry 212 may disconnect the second power supply circuitry 272 from the PA 211 by disconnecting the third terminal 813-3 from the second terminal 813-2, in order to prevent and/or reduce use of each of the third FEM 230 and the sixth FEM 860 (or use of each of the PA 231 and the PA 861) respectively connected to the second power supply circuitry 272 from being at least partially restricted due to at least partially damaged PA 211. For example, even when the PA 211 is at least partially damaged, each of the PA 221, the PA 231, the PA 841, the PA 851, and the PA 861 may be available according to disconnecting both the first power supply circuitry 271 and the second power supply circuitry 272 from the PA 211.

For example, among the first state, the second state, and the third state of the switch 813, when the PA 211 is at least partially damaged, the first state and the second state may be disabled. For example, the disabling of the first state and the second state above may be maintained until the PA 211 is restored. As a non-limiting example, the switch 813 may remain in the first state or the second state until it is identified that the PA 211 is at least partially damaged. For example, the third state may be disabled until the PA 211 is at least partially damaged.

For example, the electronic device 200 may support dual connectivity before the PA 211 is at least partially damaged, using one FEM (or one PA) among the first FEM 210 (or the PA 211) connectable to the first power supply circuitry 271, the second FEM 220 (or the PA 221) connected to the first power supply circuitry 271, the fourth FEM 840 (or the PA 841) connected to the first power supply circuitry 271, and the fifth FEM 850 (or the PA 851) connected to the first power supply circuitry 271 and one FEM (or one PA) among the third FEM 230 (or the PA 231) connected to the second power supply circuitry 272 and the sixth FEM 860 (or the PA 861) connected to the second power supply circuitry 272. For example, a first dual connectivity may be supported by combining the first FEM 210 (or the PA 211) and the third FEM 230 (or the PA 231). For example, a second dual connectivity may be supported by combining the first FEM 210 (or the PA 211) and the sixth FEM 860 (or the PA 861).

For example, after the PA 211 is at least partially damaged, the second dual connectivity supported by a combination of the first FEM 210 (or the PA 211) and the sixth FEM 860 (or the PA 861) may be replaced with a third dual connectivity supported by a combination of the third FEM 230 (or the PA 231 in the third FEM 230) and the fifth FEM 850 (or the PA 851 in the fifth FEM 850). For example, the third FEM 230 may be an FEM that supports the frequency band of the wireless signal 201. For example, the fifth FEM 850 may be an FEM that supports another frequency band of the wireless signal 806 transmitted through the sixth antenna 806 using the sixth FEM 860. For example, power supply circuits connected to the third FEM 230 and the fifth FEM 850 may be different from each other. For example, the third FEM 230 may be connected to the second power supply circuitry 272, and the fifth FEM 850 may be connected to the first power supply circuitry 271.

For example, the electronic device 200 may replace the second dual connectivity from among the first dual connectivity and the second dual connectivity with the third dual connectivity, by disconnecting the first power supply circuitry 271 from at least partially damaged PA 211. For example, even when the PA 211 is at least partially damaged, the electronic device 200 may provide an enhanced communication service by replacing the second dual connectivity with the third dual connectivity.

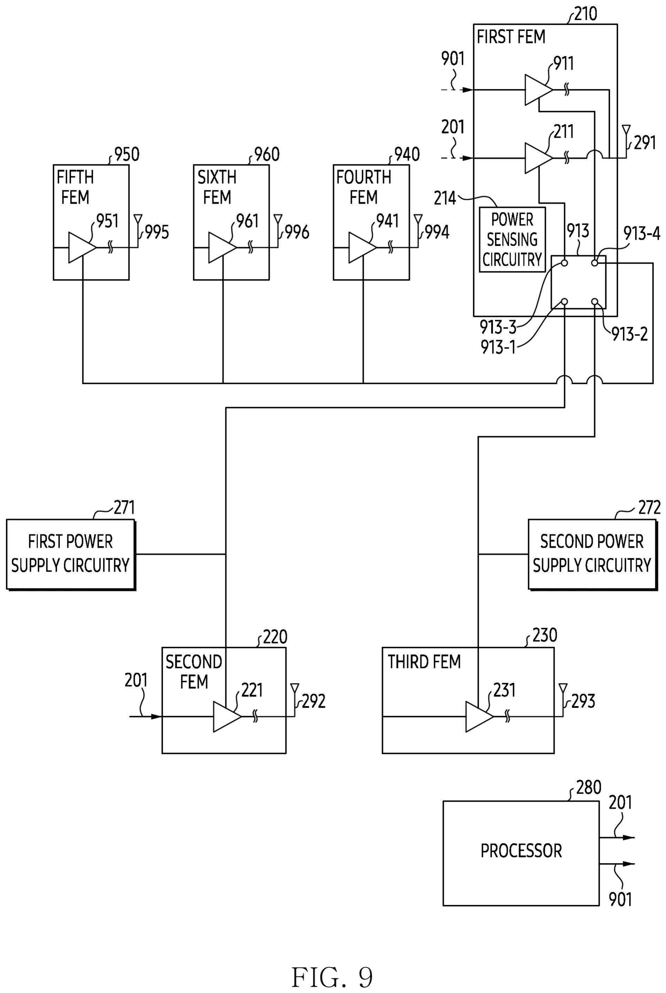

For example, at least a part of FEMs in the electronic device 200 may include a plurality of PAs. For example, the electronic device 200 may include a switch for disconnecting a part of a plurality of PAs in at least partially damaged FEM from the power supply circuitry. The switch may be illustrated in FIG. 9.

FIG. 9 illustrates an exemplary electronic device including a plurality of PAs in an FEM.

Referring to FIG. 9, an electronic device 200 may further include a fourth FEM (e.g., including various circuitry) 940, a fifth FEM (e.g., including various circuitry) 950, a sixth FEM (e.g., including various circuitry) 960, a fourth antenna 994, a fifth antenna 995, and a sixth antenna 996.

For example, the fourth FEM 940 may include a PA 941. For example, the PA 941 may be configured to obtain a transmit power of a wireless signal transmitted through the fourth antenna 994. For example, the transmit power may be obtained based on a voltage (e.g., a voltage (Vcc) for a dynamic range of the PA 941) from the first power supply circuitry 271 or the second power supply circuitry 272.

For example, the fifth FEM 950 may include a PA 951. For example, the PA 951 may be configured to obtain a transmit power of a wireless signal transmitted through the fifth antenna 995. For example, the transmit power may be obtained based on a voltage (e.g., a voltage (Vcc) for a dynamic range of the PA 951) from the first power supply circuitry 271 or the second power supply circuitry 272.

For example, the sixth FEM 960 may include a PA 961. For example, the PA 961 may be configured to obtain a transmit power of a wireless signal transmitted through the sixth antenna 996. For example, the transmit power may be obtained based on a voltage (e.g., a voltage (Vcc) for a dynamic range of the PA 961) from the first power supply circuitry 271 or the second power supply circuitry 272.

For example, the first FEM 210 may include a PA 911 as well as the PA 211. For example, the PA 911 may be used to obtain a transmit power of a wireless signal 901 transmitted through the first antenna 291. The transmit power may be obtained based on a voltage from the first power supply circuitry 271 or the second power supply circuitry 272.

For example, the first FEM 210 may include a switch 913 replacing the switch 213.

For example, the switch 913 may include a first terminal 913-1 connected to the first power supply circuitry 271, a second terminal 913-2 connected to the second power supply circuitry 272, a third terminal 913-3 connected to the PA 211, and a fourth terminal 913-4 connected to the PA 911. For example, the fourth terminal 913-4 may be further connected to each of the PA 941, the PA 951, and the PA 961.

For example, the switch 913 may have a first state connecting the first terminal 913-1 to the third terminal 913-3 of the third terminal 913-3 and the fourth terminal 913-4, a second state connecting the first terminal 913-1 to the fourth terminal 913-4 of the third terminal 913-3 and the fourth terminal 913-4, a third state connecting the second terminal 913-2 to the third terminal 913-3 of the third terminal 913-3 and the fourth terminal 913-4, a fourth state connecting the second terminal 913-2 to the fourth terminal 913-4 of the third terminal 913-3 and the fourth terminal 913-4, and a fifth state disconnecting the first terminal 913-1 from both the third terminal 913-3 and the fourth terminal 913-4 and disconnecting the second terminal 913-2 from both the third terminal 913-3 and the fourth terminal 913-4.

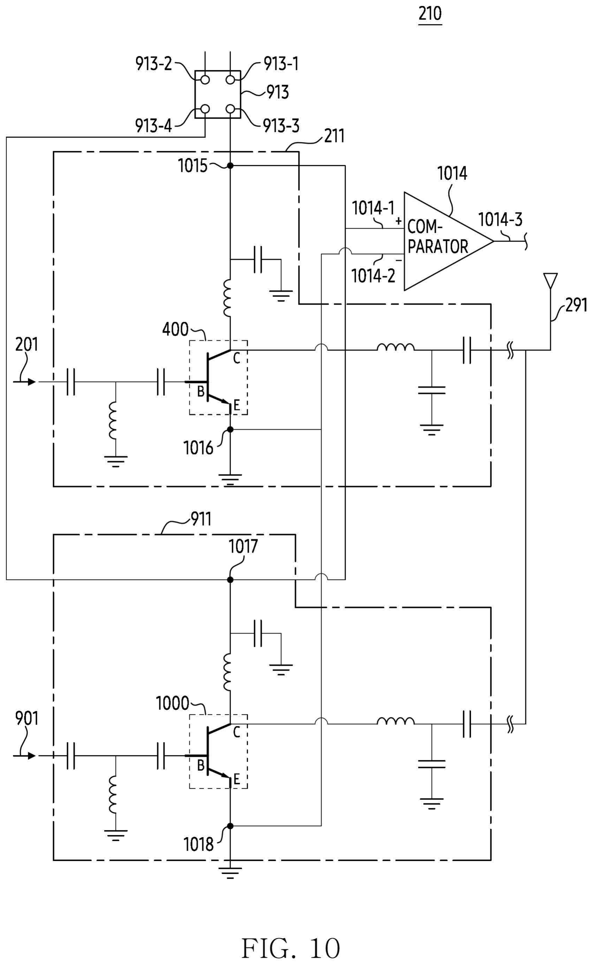

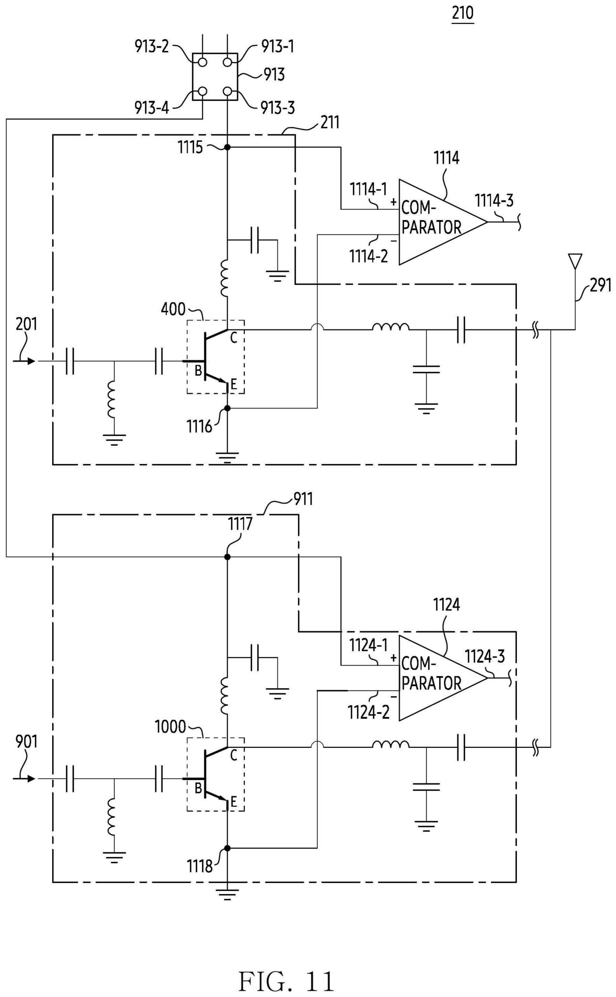

For example, the power sensing circuitry 214 may be used to identify that the PA 211 and/or the PA 911 is at least partially damaged. For example, the power sensing circuitry 214 may include at least one comparator. For example, a power sensing circuitry 214 including a single comparator may be used to identify that the PA 211 and/or the PA 911 is at least partially damaged, but may not be able to specify which PA is at least partially damaged using the power sensing circuitry 214 including the single comparator. On the other hand, a power sensing circuitry 214 including a plurality of comparators may be used to specify which PA is at least partially damaged among the PA 211 and the PA 911. The power sensing circuitry 214 including the single comparator may be illustrated in description of FIG. 10, and the power sensing circuitry 214 including the plurality of comparators described in greater detail below with reference to FIG. 11.

FIGS. 10 and 11 illustrate an example of a switch in an FEM for changing a state of a connection from a plurality of PAs.

Referring to FIG. 10, the description of the PA 211 in FIG. 3 may be applied to each of a PA 211 and a PA 911 in FIG. 10. A BJT 1000 of FIG. 10 may be implemented in the same or similar manner to the BJT 400 of FIG. 4.

For example, the first FEM 210 may include a comparator 1014 which is the single comparator. For example, the comparator 1014 may include a first input terminal 1014-1, a second input terminal 1014-2, and an output terminal 1014-3. For example, the first input terminal 1014-1 may be connected to a node 1015 and connected to a node 1017. For example, the second input terminal 1014-2 may be connected to a node 1016 and connected to a node 1018.

For example, the comparator 1014 may be configured to output a signal, from the output terminal 1014-3, indicating whether a difference value between a voltage identified through the first input terminal 1014-1 and a voltage identified through the second input terminal 1014-2 is less than the reference value. For example, the signal may be provided to the control circuitry 212, provided to the switch 913, or provided to the processor 280. For example, the signal may be used to identify whether at least one or more PAs, among the PA 211 and the PA 911, are at least partially damaged.

Referring to FIG. 11, the description of the PA 211 in FIG. 3 may be applied to each of a PA 211 and a PA 911 in FIG. 11. A BJT 1000 of FIG. 11 may be implemented in the same or similar manner to the BJT 400 of FIG. 4.

For example, the first FEM 210 may include a comparator 1114 and a comparator 1124, which are the plurality of comparators.

For example, the comparator 1114 may include a first input terminal 1114-1, a second input terminal 1114-2, and an output terminal 1114-3. For example, the first input terminal 1114-1 may be connected to a node 1115. For example, the second input terminal 1114-2 may be connected to a node 1116.

For example, the comparator 1124 may include a first input terminal 1124-1, a second input terminal 1124-2, and an output terminal 1124-3. For example, the first input terminal 1124-1 may be connected to a node 1117. For example, the second input terminal 1124-2 may be connected to a node 1118.

For example, the comparator 1114 may be configured to output a signal, from the output terminal 1114-3, indicating whether a difference value between a voltage identified through the first input terminal 1114-1 and a voltage identified through the second input terminal 1114-2 is less than the reference value. For example, the signal may be provided to the control circuitry 212, the switch 913, or the processor 280. For example, the signal may be used to identify whether the PA 211 is at least partially damaged.

For example, the comparator 1124 may be configured to output a signal from the output terminal 1124-3 indicating whether a difference value between a voltage identified through the first input terminal 1124-1 and a voltage identified through the second input terminal 1124-2 is less than the reference value. For example, the signal may be provided to the control circuitry 212, the switch 913, or the processor 280. For example, the signal may be used to identify whether the PA 911 is at least partially damaged.

For example, since the first FEM 210 in FIG. 11 includes the comparator 1114 and the comparator 1124, the power sensing circuitry 214 in the first FEM 210 may be used to determine which PA is at least partially damaged among the PA 211 and the PA 911.

Referring back to FIG. 9, when the PA 211 and/or the PA 911 are at least partially damaged, the control circuitry 212 may control the switch 913 according to a part of the operations illustrated in the description of FIGS. 5, 6 and 7.

For example, in case that the power sensing circuitry 214 includes the single comparator, the control circuitry 212 may set the state of the switch 913 to the fifth state when one or more PAs, among the PA 211 and the PA 911, are partially damaged. For example, the second FEM 220 and the third FEM 230 may be available through the fifth state of the switch 913.

For example, in case that the power sensing circuitry 214 includes the plurality of comparators, the control circuitry 212 may control the switch 913 to disconnect the PA 211 from both the first power supply circuitry 271 and the second power supply circuitry 272 when the PA 211 is at least partially damaged. For example, when the PA 211 is at least partially damaged, the first state of the switch 913 and the third state of the switch 913 may be disabled. For example, when the PA 211 is at least partially damaged, the control circuitry 212 may set the state of the switch 913 to the second state, the fourth state, or the fifth state. For example, even when the PA 211 is at least partially damaged, a PA 911 in the first FEM 210, a PA 221 in the second FEM 220, a PA 231 in the third FEM 230, a PA 941 in a fourth FEM 940, a PA 951 in a fifth FEM 950, and a PA 961 in a sixth FEM 960 may be used through the switch 913.

For example, in case that the power sensing circuitry 214 includes the plurality of comparators, the control circuitry 212 may control the switch 913 to disconnect the PA 911 from both the first power supply circuitry 271 and the second power supply circuitry 272 when the PA 911 is at least partially damaged. For example, when the PA 911 is at least partially damaged, the second state of the switch 913 and the fourth state of the switch 913 may be disabled. For example, when the PA 911 is at least partially damaged, the control circuitry 212 may set the state of the switch 913 to the first state, the third state, or the fifth state. For example, even when the PA 911 is at least partially damaged, the PA 211 in the first FEM 210, the PA 221 in the second FEM 220, and the PA 231 in the third FEM 230 may be used through the switch 913.

FIG. 9 illustrates an example in which the switch 913 is implemented as a single switch, but the switch 913 may be implemented as two switches including three terminals.

As described above, the electronic device 200 may provide an enhanced communication service by including the switch 913 in the first FEM 210.

FIG. 12 is a block diagram illustrating an electronic device 1201 in a network environment 1200 according to various embodiments. Referring to FIG. 12, the electronic device 1201 in the network environment 1200 may communicate with an electronic device 1202 via a first network 1298 (e.g., a short-range wireless communication network), or at least one of an electronic device 1204 or a server 1208 via a second network 1299 (e.g., a long-range wireless communication network). According to an embodiment, the electronic device 1201 may communicate with the electronic device 1204 via the server 1208. According to an embodiment, the electronic device 1201 may include a processor 1220, memory 1230, an input module 1250, a sound output module 1255, a display module 1260, an audio module 1270, a sensor module 1276, an interface 1277, a connecting terminal 1278, a haptic module 1279, a camera module 1280, a power management module 1288, a battery 1289, a communication module 1290, a subscriber identification module (SIM) 1296, or an antenna module 1297. In various embodiments, at least one of the components (e.g., the connecting terminal 1278) may be omitted from the electronic device 1201, or one or more other components may be added in the electronic device 1201. In various embodiments, some of the components (e.g., the sensor module 1276, the camera module 1280, or the antenna module 1297) may be implemented as a single component (e.g., the display module 1260).

The processor 1220 may execute, for example, software (e.g., a program 1240) to control at least one other component (e.g., a hardware or software component) of the electronic device 1201 coupled with the processor 1220, and may perform various data processing or computation. According to an embodiment, as at least part of the data processing or computation, the processor 1220 may store a command or data received from another component (e.g., the sensor module 1276 or the communication module 1290) in volatile memory 1232, process the command or the data stored in the volatile memory 1232, and store resulting data in non-volatile memory 1234. According to an embodiment, the processor 1220 may include a main processor 1221 (e.g., a central processing unit (CPU) or an application processor (AP)), or an auxiliary processor 1223 (e.g., a graphics processing unit (GPU), a neural processing unit (NPU), an image signal processor (ISP), a sensor hub processor, or a communication processor (CP)) that is operable independently from, or in conjunction with, the main processor 1221. For example, when the electronic device 1201 includes the main processor 1221 and the auxiliary processor 1223, the auxiliary processor 1223 may be adapted to consume less power than the main processor 1221, or to be specific to a specified function. The auxiliary processor 1223 may be implemented as separate from, or as part of the main processor 1221.

The auxiliary processor 1223 may control at least some of functions or states related to at least one component (e.g., the display module 1260, the sensor module 1276, or the communication module 1290) among the components of the electronic device 1201, instead of the main processor 1221 while the main processor 1221 is in an inactive (e.g., sleep) state, or together with the main processor 1221 while the main processor 1221 is in an active state (e.g., executing an application). According to an embodiment, the auxiliary processor 1223 (e.g., an image signal processor or a communication processor) may be implemented as part of another component (e.g., the camera module 1280 or the communication module 1290) functionally related to the auxiliary processor 1223. According to an embodiment, the auxiliary processor 1223 (e.g., the neural processing unit) may include a hardware structure specified for artificial intelligence model processing. An artificial intelligence model may be generated by machine learning. Such learning may be performed, e.g., by the electronic device 1201 where the artificial intelligence is performed or via a separate server (e.g., the server 1208). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1230 may store various data used by at least one component (e.g., the processor 1220 or the sensor module 1276) of the electronic device 1201. The various data may include, for example, software (e.g., the program 1240) and input data or output data for a command related thereto. The memory 1230 may include the volatile memory 1232 or the nonvolatile memory 1234.

The program 1240 may be stored in the memory 1230 as software, and may include, for example, an operating system (OS) 1242, middleware 1244, or an application 1246.

The input module 1250 may receive a command or data to be used by another component (e.g., the processor 1220) of the electronic device 1201, from the outside (e.g., a user) of the electronic device 1201. The input module 1250 may include, for example, a microphone, a mouse, a keyboard, a key (e.g., a button), or a digital pen (e.g., a stylus pen).

The sound output module 1255 may output sound signals to the outside of the electronic device 1201. The sound output module 1255 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1260 may visually provide information to the outside (e.g., a user) of the electronic device 1201. The display module 1260 may include, for example, a display, a hologram device, or a projector and control circuitry to control a corresponding one of the display, hologram device, and projector. According to an embodiment, the display module 1260 may include a touch sensor adapted to detect a touch, or a pressure sensor adapted to measure the intensity of force incurred by the touch.

The audio module 1270 may convert a sound into an electrical signal and vice versa. According to an embodiment, the audio module 1270 may obtain the sound via the input module 1250, or output the sound via the sound output module 1255 or a headphone of an external electronic device (e.g., an electronic device 1202) directly (e.g., wiredly) or wirelessly coupled with the electronic device 1201.

The sensor module 1276 may detect an operational state (e.g., power or temperature) of the electronic device 1201 or an environmental state (e.g., a state of a user) external to the electronic device 1201, and then generate an electrical signal or data value corresponding to the detected state. According to an embodiment, the sensor module 1276 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1277 may support one or more specified protocols to be used for the electronic device 1201 to be coupled with the external electronic device (e.g., the electronic device 1202) directly (e.g., wiredly) or wirelessly. According to an embodiment, the interface 1277 may include, for example, a high definition multimedia interface (HDMI), a universal serial bus (USB) interface, a secure digital (SD) card interface, or an audio interface.

A connecting terminal 1278 may include a connector via which the electronic device 1201 may be physically connected with the external electronic device (e.g., the electronic device 1202). According to an embodiment, the connecting terminal 1278 may include, for example, a HDMI connector, a USB connector, a SD card connector, or an audio connector (e.g., a headphone connector).

The haptic module 1279 may convert an electrical signal into a mechanical stimulus (e.g., a vibration or a movement) or electrical stimulus which may be recognized by a user via his tactile sensation or kinesthetic sensation. According to an embodiment, the haptic module 1279 may include, for example, a motor, a piezoelectric element, or an electric stimulator.

The camera module 1280 may capture a still image or moving images. According to an embodiment, the camera module 1280 may include one or more lenses, image sensors, image signal processors, or flashes.

The power management module 1288 may manage power supplied to the electronic device 1201. According to an embodiment, the power management module 1288 may be implemented as at least part of, for example, a power management integrated circuit (PMIC).

The battery 1289 may supply power to at least one component of the electronic device 1201. According to an embodiment, the battery 1289 may include, for example, a primary cell which is not rechargeable, a secondary cell which is rechargeable, or a fuel cell.

The communication module 1290 may support establishing a direct (e.g., wired) communication channel or a wireless communication channel between the electronic device 1201 and the external electronic device (e.g., the electronic device 1202, the electronic device 1204, or the server 1208) and performing communication via the established communication channel. The communication module 1290 may include one or more communication processors that are operable independently from the processor 1220 (e.g., the application processor (AP)) and supports a direct (e.g., wired) communication or a wireless communication. According to an embodiment, the communication module 1290 may include a wireless communication module 1292 (e.g., a cellular communication module, a short-range wireless communication module, or a global navigation satellite system (GNSS) communication module) or a wired communication module 1294 (e.g., a local area network (LAN) communication module or a power line communication (PLC) module). A corresponding one of these communication modules may communicate with the external electronic device via the first network 1298 (e.g., a short-range communication network, such as Bluetooth^{™}, wireless-fidelity (Wi-Fi) direct, or infrared data association (IrDA)) or the second network 1299 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1292 may identify and authenticate the electronic device 1201 in a communication network, such as the first network 1298 or the second network 1299, using subscriber information (e.g., international mobile subscriber identity (IMSI)) stored in the subscriber identification module 1296.

The wireless communication module 1292 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1292 may support a high-frequency band (e.g., the mmWave band) to achieve, e.g., a high data transmission rate. The wireless communication module 1292 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1292 may support various requirements specified in the electronic device 1201, an external electronic device (e.g., the electronic device 1204), or a network system (e.g., the second network 1299). According to an embodiment, the wireless communication module 1292 may support a peak data rate (e.g., 20Gbps or more) for implementing eMBB, loss coverage (e.g., 1264dB or less) for implementing mMTC, or U-plane latency (e.g., 0.5ms or less for each of downlink (DL) and uplink (UL), or a round trip of 12ms or less) for implementing URLLC.

The antenna module 1297 may transmit or receive a signal or power to or from the outside (e.g., the external electronic device) of the electronic device 1201. According to an embodiment, the antenna module 1297 may include an antenna including a radiating element including a conductive material or a conductive pattern formed in or on a substrate (e.g., a printed circuit board (PCB)). According to an embodiment, the antenna module 1297 may include a plurality of antennas (e.g., array antennas). In such a case, at least one antenna appropriate for a communication scheme used in the communication network, such as the first network 1298 or the second network 1299, may be selected, for example, by the communication module 1290 (e.g., the wireless communication module 1292) from the plurality of antennas. The signal or the power may then be transmitted or received between the communication module 1290 and the external electronic device via the selected at least one antenna. According to an embodiment, another component (e.g., a radio frequency integrated circuit (RFIC)) other than the radiating element may be additionally formed as part of the antenna module 1297.

According to various embodiments, the antenna module 1297 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1201 and the external electronic device 1204 via the server 1208 coupled with the second network 1299. Each of the electronic devices 1202 or 1204 may be a device of a same type as, or a different type, from the electronic device 1201. According to an embodiment, all or some of operations to be executed at the electronic device 1201 may be executed at one or more of the external electronic devices 1202, 1204, or 1208. For example, if the electronic device 1201 should perform a function or a service automatically, or in response to a request from a user or another device, the electronic device 1201, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1201. The electronic device 1201 may provide the outcome, with or without further processing of the outcome, as at least part of a reply to the request. To that end, a cloud computing, distributed computing, mobile edge computing (MEC), or client-server computing technology may be used, for example. The electronic device 1201 may provide ultra low-latency services using, e.g., distributed computing or mobile edge computing. In an embodiment, the external electronic device 1204 may include an internet-of-things (IoT) device. The server 1208 may be an intelligent server using machine learning and/or a neural network. According to an embodiment, the external electronic device 1204 or the server 1208 may be included in the second network 1299. The electronic device 1201 may be applied to intelligent services (e.g., smart home, smart city, smart car, or healthcare) based on 5G communication technology or IoT-related technology.

The technical problems addressed in the disclosure are not limited to those described above, and other technical problems not mentioned herein will be clearly understood by those having ordinary skill in the art to which the present disclosure belongs, from the description.

The effects that can be obtained from the present disclosure are not limited to those described above, and any other effects not mentioned herein will be clearly understood by those having ordinary skill in the art to which the present disclosure belongs, from the description.

As described above, according to an example embodiment, an electronic device may comprise: a first antenna and a second antenna, power supply circuitry, a first front end module (FEM) including a switch, a power amplifier (PA) connected to the power supply circuitry through the switch to obtain a transmit (Tx) power of a first wireless signal transmitted through the first antenna based on a voltage from the power supply circuitry, and control circuitry, and a second FEM including a PA connected to the power supply circuitry to obtain a Tx power of a second wireless signal transmitted through the second antenna based on the voltage from the power supply circuitry , wherein the control circuitry may be configured to: obtain a signal indicating whether the PA in the first FEM connected to the power supply circuitry through the switch is at least partially damaged; and control the switch to disconnect the power supply circuitry from the PA in the first FEM, in response to the signal indicating that the PA in the first FEM is at least partially damaged.

According to an example embodiment, the power supply circuitry may be disconnected from the PA in the first FEM to maintain providing the voltage from the power supply circuitry to the PA in the second FEM.

According to an example embodiment, the first FEM may further include a comparator configured to provide, to the control circuitry, the signal indicating whether a difference value between the voltage from the power supply circuitry and a voltage of a source of a transistor included in the PA in the first FEM is less than a reference value. The control circuitry may be configured to obtain, from the comparator, the signal indicating that the PA in the first FEM is at least partially damaged as indicating that the difference value is less than the reference value.

According to an example embodiment, the control circuitry may be configured to obtain, from the comparator, the signal indicating that the PA in the first FEM is not damaged as indicating that the difference value is greater than or equal to the reference value, and maintain a connection between the power supply circuitry and the PA in the first FEM, which is formed through the switch, based on the signal indicating that the PA in the first FEM is not damaged.

According to an example embodiment, the electronic device may comprise at least one processor, comprising processing circuitry, a third antenna, and a third FEM for the third antenna. The control circuitry may be configured to obtain, from the comparator, the signal indicating that the PA in the first FEM is at least partially damaged, and provide, to the at least one processor, data indicating that the PA in the first FEM is at least partially damaged in response to the signal indicating that the PA in the first FEM is at least partially damaged. The At least one processor, individually and/or collectively, may be configured to cease providing the first wireless signal to the first FEM and provide the first wireless signal to the third FEM supporting a frequency band of the first wireless signal. The first wireless signal may be transmitted, using the third FEM, through the third antenna.

According to an example embodiment, the electronic device may comprise additional power supply circuitry. The third FEM may include a PA connected to the additional power supply circuitry. The first wireless signal may be transmitted with a Tx power obtained using the PA in the third FEM through the third antenna, based on a voltage from the additional power supply circuitry, based on the PA in the first FEM being at least partially damaged.

According to an example embodiment, the electronic device may comprise additional power supply circuitry. The switch may include a first terminal connected to the power supply circuitry, a second terminal connected to the additional power supply circuitry, and a third terminal connected to the PA in the first FEM. The control circuitry be configured to in response to the signal indicating that the PA in the first FEM is at least partially damaged, disconnect the power supply circuitry from the PA in the first FEM by disconnecting the third terminal from the first terminal and disconnect the additional power supply circuitry from the PA in the first FEM by disconnecting the third terminal from the second terminal.

According to an example embodiment, the electronic device may comprise a third antenna and a third FEM, including a PA connected to the additional power supply circuitry, for the third antenna. The additional power supply circuitry may be disconnected from the PA in the first FEM to maintain providing, to the PA in the third FEM, the voltage from the additional power supply circuitry.

According to an example embodiment, a first state connecting the third terminal to the first terminal and a second state connecting the third terminal to the second terminal from among the first state, the second state, and a third state disconnecting the third terminal from both the first terminal and the second terminal may be disabled in response to the signal indicating that the PA in the first FEM is at least partially damaged.

According to an example embodiment, the switch may be in the first state or the second state, while the signal indicating that the PA in the first FEM is not damaged is obtained.

According to an example embodiment, the third state may be disabled, while the signal indicating that the PA in the first FEM is not damaged is obtained.

According to an example embodiment, the second FEM may include a switch and control circuitry. The PA in the second FEM may be connected through the switch in the second FEM to the power supply circuitry. The control circuitry in the second FEM may be configured to obtain a signal indicating whether the PA in the second FEM connected to the power supply circuitry through the switch in the second FEM is at least partially damaged, and disconnect the power supply circuitry from the PA in the second FEM in response to the signal indicating that the PA in the second FEM is at least partially damaged.

According to an example embodiment, the control circuitry in the second FEM may be configured to maintain, through the switch in the second FEM, a connection between the PA in the second FEM and the power supply circuitry, based on the signal indicating that the PA in the second FEM is not damaged.

According to an example embodiment, the control circuitry may be configured to maintain a connection between the PA in the first FEM and the power supply circuitry, based on the signal indicating that the PA in the first FEM is not damaged.

According to an example embodiment, the first FEM may include a comparator. The PA in the first FEM may include first matching circuitry connected to the switch, second matching circuitry, a transistor including a drain connected to the switch through the first matching circuitry, a source connected to a ground, and a gate configured to obtain the first wireless signal through the second matching circuitry. The control circuitry may be configured to obtain, from the comparator, the signal indicating whether the PA in the first FEM is at least partially damaged as indicating whether a difference value between the voltage and a voltage of the source is less than a reference value.

As described above, according to an example embodiment, an electronic device may comprise at least one processor, comprising processing circuitry, a first antenna and a second antenna, power supply circuitry, a first front end module (FEM) including a switch, a power amplifier (PA) connected to the power supply circuitry 71 through the switch to obtain a transmit (Tx) power of a first wireless signal obtained from the at least one processor and transmitted through the first antenna based on a voltage from the power supply circuitry, and control circuitry, and a second FEM including a PA connected to the power supply circuitry to obtain a Tx power of a second wireless signal obtained from the at least one processor and transmitted through the second antenna based on the voltage from the power supply circuitry. The control circuitry may be configured to obtain, from the at least one processor, a signal indicating that the PA in the first FEM connected to the power supply circuitry through the switch is at least partially damaged, and control the switch to disconnect the power supply circuitry from the PA in the first FEM in response to the signal.

According to an example embodiment, the first FEM may include a comparator configured to provide, to the at least one processor, another signal indicating that a difference value between the voltage from the power supply circuitry and a voltage of a source of a transistor included in the PA in the first FEM is less than a reference value. The at least one processor, individually and/or collectively, may be configured to provide the signal to the control circuitry in response to the other signal indicating that the difference value is less than the reference value.

As described above, according to an example embodiment, an electronic device may comprise at least one processor, comprising processing circuitry, a first antenna and a second antenna, power supply circuitry, a first front end module (FEM) including a switch, a power amplifier (PA) connected to the power supply circuitry through the switch to obtain a transmit (Tx) power of a first wireless signal obtained from the at least one processor and transmitted through the first antenna based on a voltage from the power supply circuitry, and control circuitry, and a second FEM including a PA connected to the power supply circuitry to obtain a Tx power of a second wireless signal obtained from the at least one processor and transmitted through the second antenna based on the voltage from the power supply circuitry. The control circuitry may be configured to identify that the PA in the first FEM is at least partially damaged by identifying a state of the switch disconnecting the power supply circuitry from the PA in the first FEM, and provide data indicating that the PA in first FEM is at least partially damaged to the processor in response to the identification.

According to an example embodiment, the first FEM may include a comparator configured to provide, to the switch, a signal indicating whether a difference value between the voltage from the power supply circuitry and a voltage of a source of a transistor included in the PA in the first FEM is less than a reference value. The switch may be configured to disconnect the power supply circuitry from the PA in the first FEM, in response to the signal indicating that the difference value is less than the reference value.

According to an example embodiment, the electronic device may comprise a third antenna and a third FEM for the third antenna. The At least one processor, individually and/or collectively, may be configured to, in response to the data, cease providing the first wireless signal to the first FEM and provide the first wireless signal to the third FEM supporting a frequency band of the first wireless signal. The first wireless signal may be transmitted, using the third FEM, through the third antenna.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance, or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1240) including one or more instructions that are stored in a storage medium (e.g., internal memory 1236 or external memory 1238) that is readable by a machine (e.g., the electronic device 1201). For example, a processor (e.g., the processor 1220) of the machine (e.g., the electronic device 1201) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. An electronic device comprising:
a first antenna and a second antenna;
power supply circuitry;
a first front end module (FEM) including a switch, a power amplifier (PA) connected to the power supply circuitry through the switch to obtain a transmit (Tx) power of a first wireless signal transmitted through the first antenna based on a voltage from the power supply circuitry, and control circuitry; and
a second FEM including a PA connected to the power supply circuitry to obtain a Tx power of a second wireless signal transmitted through the second antenna based on the voltage from the power supply circuitry,
wherein the control circuitry is configured to:
obtain a signal indicating whether the PA in the first FEM connected to the power supply circuitry through the switch is at least partially damaged; and
in response to the signal indicating that the PA in the first FEM is at least partially damaged, control the switch to disconnect the power supply circuitry from the PA in the first FEM.

2. The electronic device of claim 1, wherein the power supply circuitry is configured to be disconnected from the PA in the first FEM to maintain providing the voltage from the power supply circuitry to the PA in the second FEM.

3. The electronic device of claim 1, wherein the first FEM further includes a comparator configured to provide, to the control circuitry, the signal indicating whether a difference value between the voltage from the power supply circuitry and a voltage of a source of a transistor included in the PA in the first FEM is less than a reference value, and
wherein the control circuitry is configured to obtain, from the comparator, the signal indicating that the PA in the first FEM is at least partially damaged based on indicating that the difference value is less than the reference value.

4. The electronic device of claim 3, wherein the control circuitry is further configured to:
obtain, from the comparator, the signal indicating that the PA in the first FEM is not damaged based on indicating that the difference value is greater than or equal to the reference value; and
maintain, based on the signal indicating that the PA in the first FEM is not damaged, a connection between the power supply circuitry and the PA in the first FEM.

5. The electronic device of claim 2, further comprising:
at least one processor, comprising processing circuitry;
a third antenna; and
a third FEM for the third antenna,
wherein the control circuitry is configured to:
obtain, from the comparator, the signal indicating that the PA in the first FEM is at least partially damaged; and
in response to the signal indicating that the PA in the first FEM is at least partially damaged, provide, to the processor, data indicating that the PA in the first FEM is at least partially damaged,
wherein the at least one processor, individually and/or collectively, is configured to cease providing the first wireless signal to the first FEM and provide the first wireless signal to the third FEM supporting a frequency band of the first wireless signal, and
wherein the third FEM is configured to transmit the first wireless signal, through the third antenna.

6. The electronic device of claim 5, further comprising:
another power supply circuitry,
wherein the third FEM includes a PA connected to the another power supply circuitry,
wherein the third FEM is configured to transmit the first wireless signal with a Tx power obtained using the PA in the third FEM through the third antenna, based on a voltage from the another power supply circuitry, based on the PA in the first FEM being at least partially damaged.

7. The electronic device of claim 1, further comprising:
another power supply circuitry,
wherein the switch includes a first terminal connected to the power supply circuitry, a second terminal connected to the another power supply circuitry, and a third terminal connected to the PA in the first FEM, and
wherein the control circuitry is configured to:
in response to the signal indicating that the PA in the first FEM is at least partially damaged, disconnect the power supply circuitry from the PA in the first FEM by disconnecting the third terminal from the first terminal and disconnect the another power supply circuitry from the PA in the first FEM by disconnecting the third terminal from the second terminal.

8. The electronic device of claim 7, further comprising:
a third antenna; and
a third FEM, including a PA connected to the another power supply circuitry, for the third antenna,
wherein the other power supply circuitry is disconnected from the PA in the first FEM to maintain providing, to the PA in the third FEM, the voltage from the other power supply circuitry.

9. The electronic device of claim 7, wherein a first state connecting the third terminal to the first terminal and a second state connecting the third terminal to the second terminal from among the first state, the second state, and a third state disconnecting the third terminal from both the first terminal and the second terminal are disabled in response to the signal indicating that the PA in the first FEM is at least partially damaged.

10. The electronic device of claim 9, wherein the switch is in the first state or the second state, based on the signal indicating that the PA in the first FEM is not damaged being obtained.

11. The electronic device of claim 10, wherein the third state is disabled, based on the signal indicating that the PA in the first FEM is not damaged being obtained.

12. The electronic device of claim 1, wherein the second FEM includes:
a switch; and
control circuitry,
wherein the PA in the second FEM is connected through the switch in the second FEM to the power supply circuitry, and
wherein the control circuitry in the second FEM is configured to:
obtain a signal indicating whether the PA in the second FEM connected to the power supply circuitry through the switch in the second FEM is at least partially damaged; and
in response to the signal indicating that the PA in the second FEM is at least partially damaged, disconnect the power supply circuitry from the PA in the second FEM.

13. The electronic device of claim 12, wherein the control circuitry in the second FEM is further configured to maintain, through the switch in the second FEM, a connection between the PA in the second FEM and the power supply circuitry, based on the signal indicating that the PA in the second FEM is not damaged.

14. The electronic device of claim 1, wherein the control circuitry is further configured to maintain a connection between the PA in the first FEM and the power supply circuitry, based on the signal indicating that the PA in the first FEM is not damaged.

15. The electronic device of claim 1, wherein the first FEM further includes a comparator,
wherein the PA in the first FEM includes:
first matching circuitry connected to the switch;
second matching circuitry; and
a transistor including a drain connected to the switch through the first matching circuitry, a source connected to a ground, and a gate configured to obtain the first wireless signal through the second matching circuitry, and
wherein the control circuitry is configured to obtain, from the comparator, the signal indicating whether the PA in the first FEM is at least partially damaged based on a difference value between the voltage and a voltage of the source is less than a reference value.
